(19) Europäisches Patentamt
European Patent Office
Office européen des brevets

(11) Veröffentlichungsnummer: **0 568 889 A2**

(12) **EUROPÄISCHE PATENTANMELDUNG**

(21) Anmeldenummer: **93106709.4**

(51) Int. Cl.[5]: **G01R 35/00**

(22) Anmeldetag: **26.04.93**

(30) Priorität: **02.05.92 DE 4214660**

(43) Veröffentlichungstag der Anmeldung:
**10.11.93 Patentblatt 93/45**

(84) Benannte Vertragsstaaten:
**CH DE FR GB LI NL**

(71) Anmelder: **Laboratorium Prof. Dr. Rudolf Berthold GmbH & Co.**
**Calmbacher Strasse 22**
**D-75323 Bad Wildbad(DE)**

(72) Erfinder: **Heuermann, Holger, Dipl.-Ing.**
**Ruhr Universität Bochum,**
**Inst. Hochfrequenztechnik**
**W-4630 Bochum 1(DE)**
Erfinder: **Schiek, Burkhard, Prof. Dr.-Ing.**
**Ruhr Universität Bochum,**
**Inst. Hochfrequenztechnik**
**W-4630 Bochum 1(DE)**

(74) Vertreter: **Frank, Gerhard, Dipl.-Phys. et al**
**Patentanwälte**
**Mayer, Frank, Reinhardt,**
**Westliche 24**
**D-75172 Pforzheim (DE)**

(54) **Verfahren zum Kalibrieren eines Netzwerkanalysators.**

(57) Zum Kalibrieren eines Netzwerkanalysators, der zwei Meßtore aufweist, die über Leitungen oder über den freien Raum mit einem Meßobjekt verbindbar sind, werden mit einer ersten Kalibriermessung die Transmissions- und Reflexions-Parameter an einer reflexionsfrei zwischen die beiden Meßtore geschalteten Leitung bzw. an der Freiraum-Verbindung gemessen; dann werden mit der gleichen Freiraum-Verbindung bzw. mit der gleichen Leitung zwei bzw. drei weitere Kalibriermessungen an Kalibrierstandards durchgeführt, die durch an zwei bzw. drei verschiedenen Stellen in der Freiraum-Verbindung bzw. die Leitung eingefügte reflexionssymmetrische und reziproke Störobjekte realisiert sind.

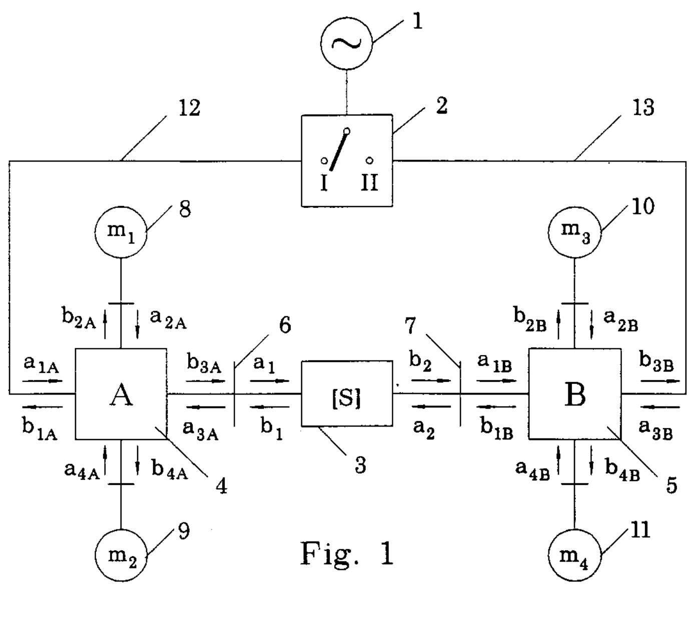

Fig. 1

EP 0 568 889 A2

Netzwerkanalysatoren, mit denen an einem zwischen zwei Meßtoren angeordneten beliebigen Meßobjekt dessen Transmissions- und Reflexions-Parameter gemessen werden, müssen zur Korrektur von Systemsfehlern mittels sogenannter Kalibrierstandards kalibriert werden (beispielsweise nach US-PS 4 982 164). Aus den durch diese Kalibriermessungen gewonnenen Meßwerten werden über spezielle Rechenverfahren Korrekturwerte bzw. Fehlerkenngrößen berechnet, die anschließend bei der eigentlichen Objektmessung berücksichtigt werden.

Alle bisher üblichen Kalibrierverfahren besitzen den gemeinsamen Nachteil, daß während des Kalibriervorgangs die einzelnen Kalibrierstandards nacheinander an- und abgeschaltet, also neu kontaktiert werden müssen. Dieser mehrfache Wechsel der Kalibrierstandards ist besonders störend, wenn dabei Löt- oder Bond-Verbindungen zwischen den Meßtoren und den Standards gelöst und neu hergestellt werden müssen. Besonders nachteilig ist die Anwendung der bekannten Kalibrierverfahren auch bei solchen Netzwerkanalysatoren, bei denen an die Meßtore Antennen zum Abstrahlen von elektromagnetischen Wellen angeschlossen sind und bei denen im freien Raum zwischen den im Abstand voneinander angeordneten Strahlern dann Objektmessungen, beispielsweise Feuchtigkeitsmessungen an im elektromagnetischen Feld zwischen den Strahlern angeordneten Meßobjekten durchgeführt werden sollen. Bei letzterer Art von Netzwerkanalysatoren ist eine Kalibrierung nach den bekannten Kalibrierverfahren nur dadurch möglich, daß die Strahler nacheinander in verschiedenen gegenseitigen Abständen angeordnet werden, und diese Abstände genau vermessen werden, was im Millimeterwellenbereich nicht mehr mit Präzision durchführbar ist.

Es ist daher Aufgabe der Erfindung, ein Kalibrierverfahren für Netzwerkanalysatoren zu schaffen, bei dem diese Nachteile vermieden sind und mit dem sowohl bei Netzwerkanalysatoren mit Leitungsverbindung als auch bei Netzwerkanalysatoren mit Freiraumverbindung zum Meßobjekt auf einfache Weise eine genaue Kalibrierung durchführbar ist.

Diese Aufgabe wird für einen Netzwerkanalysator mit Leitungsverbindung durch ein Verfahren nach Anspruch 1 oder 2 und für einen Netzwerkanalysator mit Freiraumverbindung zum Meßobjekt durch ein Verfahren nach Anspruch 3 gelöst. Vorteilhafte Weiterbildungen ergeben sich aus den darauffolgenden Unteransprüchen.

Beim Verfahren nach Anspruch 1 oder 2 ist eine Lösung der Verbindung zwischen den Meßtoren und der zur ersten Kalibriermessung vorgesehenen reflexionsfreien Leitung (z.B. Streifen-Leitung oder Hohlleiter) während der anschließenden Kalibriermessungen nicht mehr nötig, da für diese anschließenden Kalibriermessungen die gleiche Leitung bzw. der gleiche Hohlleiter benutzt wird und nur durch Einbringung von entsprechenden Störstellen die zusätzlichen Kalibrierstandards realisiert werden. Wenn von der Leitung für die erste Kalibriermessung die Ausbreitungskonstante für elektromagnetische Wellen nicht bekannt ist, was bei Ausbildung dieser Leitung beispielsweise als Streifenleitung meist der Fall ist, da hier die Ausbreitungskonstante von dem Trägermaterial der Streifenleitung abhängt, sind gemäß Anspruch 1 insgesamt vier Kalibriermessungen nötig, wenn dagegen die Ausbreitungskonstante bekannt ist, was für Präzisionsleitungen wie Luftleitungen oder Hohlleiter und auch für die Freiraumverbindung gilt, sind nur insgesamt drei Kalibriermessungen erforderlich.

Die für die weiteren Kalibriermessungen erforderlichen Störobjekte an der Leitung, am Hohlleiter oder an der Freiraumverbindung können auf einfache Weise realisiert werden, es ist nur erforderlich, daß diese Störobjekte reflexionssymmetrisch sind, d.h. von beiden Seiten die gleiche Reflexion für elektromagnetische Wellen aufweisen, und außerdem reziprok sind, d.h. in beiden Richtungen gleiche Transmission aufweisen. Für eine auf einem Substrat ausgebildete Streifenleitung werden nach Ausführung der ersten Kalibriermessung an drei verschiedenen Stellen der Streifenleitung Klötze aufgesetzt, die für Hochfrequenz wie ein Kondensator zwischen den Streifenleitungen an der aufgesetzten Stelle wirken und damit die geforderten Störeigenschaften (reflexionssymmetrisch und reziprok) aufweisen. Für alle vier erforderlichen Kalibriermessungen bleibt die Streifenleitung beispielsweise über Bonddrähte fest mit den Meßtoren des Netzwerkanalysators verbunden, die Länge der Leitung bleibt für alle Kalibriermessungen gleich lang und damit auch der Abstand zwischen den Meßtoren.

Bei dem Verfahren nach Anspruch 2 unter Verwendung eines Hohlleiters vorbestimmter Länge zwischen den beiden Meßtoren für die erste Kalibriermessung können die reflexionssymmetrischen, reziproken Störobjekte innerhalb des Hohlleiters an zwei oder drei verschiedenen Stellen längs des Hohlleiters beispielsweise auf einfache Weise durch Stäbe aus dielektrischem Material realisiert werden, die über Löcher in der Wand des Hohlleiters an verschiedenen Stellen nacheinander eingesetzt werden. Noch einfacher ist die Realisierung dieser Störobjekte bei einer Freiraumverbindung nach Anspruch 3, hier genügt es, eine Kugel oder Platte aus einem Material, das für elektromagnetische Wellen reflexionssymmetrisch und reziprok ist, an zwei verschiedenen Stellen im Freiraum zwischen den Antennen anzuordnen, wobei auch in diesem Fall der Abstand der Antennenstrahler für alle Kalibriermessungen unverändert bleibt.

Das erfindungsgemäße Verfahren ermöglicht außerdem erstmals eine vollautomatische Kalibrierung eines Netzwerkanalysators, da zwischen den einzelnen Kalibriermessungen keine Verbindungen gelöst oder umgeschaltet werden müssen und die Verschiebung der Kalibrierobjekte zu den einzelnen vorbestimmten Stellen auf einfache Weise mittels eines entsprechend gesteuerten elektromagnetischen Antriebes automatisch durchgeführt werden kann.

Die Kalibriergenauigkeit hängt nur von der Reproduzierbarkeit der zwei oder drei Störobjekte während des Kalibriervorgangs ab, für eine Kalibrierung mit einer Streifenleitung, auf welche beispielsweise in verschiedenen Positionen ein Klotz aufgesetzt wird, nur von der Genauigkeit der Reproduzierbarkeit des Andruckes dieses Klotzes auf die Streifenleitung. Die Abstände der verschiedenen Positionen der Störobjekte voneinander können im Prinzip beliebig sein, besonders vorteilhaft ist es jedoch, hierfür äquidistante Abstände zu wählen, da hierdurch die rechnerische Auswertung erleichtert wird.

Ein weiterer Vorteil des erfindungsgemäßen Verfahrens besteht darin, daß hiermit auf einfache Weise genau und schnell die Ausbreitungskonstante für elektromagnetische Wellen längs einer Leitung bestimmt werden kann, dazu ist es nur erforderlich, die Abstände der Störobjekte exakt zu bestimmen.

Die Reihenfolge der einzelnen Kalibriermessungen kann beliebig sein. Bei der Kalibrierung mit Leitungen dient der Wellenwiderstand der Leitung als Bezugsimpedanz, bei der Kalibrierung im Freiraum ist der Freiraumwellenwiderstand die Bezugsimpedanz.

Das erfindungsgemäße Verfahren ermöglicht erstmals eine Freiraumkalibrierung im Mikrowellen- und Millimeterwellen-Bereich, da während der Kalibrierung der Abstand zwischen den Antennen gleich bleibt und eine exakte Abstandsvermessung überflüssig ist.

Die Erfindung wird im folgenden anhand schematischer Zeichnungen an Ausführungsbeispielen näher erläutert.

Fig. 1 zeigt das Prinzipschaltbild eines üblichen Netzwerkanalysators (beispielsweise Netzwerkanalysator ZPV-Z5 der Fa. Rohde & Schwarz), bei dem über ein Dreitor 2, beispielsweise einen Umschalter, zwei getrennte Meßzweige 12 und 13 aus einem Hochfrequenzgenerator 1, der in einem vorgegebenen Frequenzbereich durchstimmbar ist, gespeist sind. Die beiden wechselweise anschaltbaren Meßzweige 12 und 13 führen zu Viertoren 4 und 5, die als Meßbrücken oder Richtkoppler ausgebildet sind und mit denen Signaldetektoren 8, 9 bzw. 10, 11 verbunden sind, mittels welcher Spannungsmessungen nach Betrag und Phase durchführbar sind. Diese Signaldetektoren können fehlangepaßt sein. Mit den Viertoren 4 und 5 sind außerdem Meßtore 6 und 7 verbunden, zwischen welchen ein Zweitor 3 als Meßobjekt einschaltbar ist. Über die Signaldetektoren 7, 8 und 10, 11 können so an einem zwischengeschalteten Meßobjekt 3 an dessen Eingang und Ausgang jeweils die komplexen Reflexionsfaktoren $S_{11}$ und $S_{22}$ gemessen werden und ebenso die komplexen Transmissionsfaktoren $S_{21}$ und $S_{12}$ in Vorwärts- und Rückwärtsrichtung. Durch diese vier gemessenen komplexen Streuparameter $S_{11}$, $S_{22}$, $S_{12}$ und $S_{21}$ ist damit für jede Frequenz ein lineares Zweitor vollständig beschrieben und es können aus diesen Werten alle weiteren interessierenden Meßgrößen bestimmt werden.

Zur Bestimmung von Systemfehlern ist bei solchen Netzwerkanalysatoren (NWA) vor der eigentlichen Objektmessung eine Kalibriermessung erforderlich. Dazu werden anstelle des Meßobjektes 3 verschiedene Kalibrierstandards zwischen die Meßtore 6 und 7 geschaltet und damit jeweils wieder die Streuparameter ermittelt, aus denen dann die jeweiligen Fehlerkenngrößen des Netzwerkanalysators ermittelt werden, die gespeichert werden und bei der späteren Objektmessung entsprechend berücksichtigt werden.

Die Meßtore 6 und 7 können bei Netzwerkanalysatoren dieser Art verschieden ausgebildet sein, sie können beispielsweise als Koaxialbuchsen bzw. Koaxialstecker ausgebildet sein oder als Hohlleiteranschlüsse oder sie können unmittelbar mit im Abstand voneinander angeordneten Antennen verbunden sein, die zwischen sich ein elektromagnetisches Feld erzeugen. Das erfindungsgemäße Kalibrierprinzip ist für all diese verschiedenen Meßtorausbildungen geeignet.

Fig. 2 zeigt im Querschnitt die Anwendung der Erfindung bei einem Netzwerkanalysator, dessen Meßtore 6 und 7 als auf einem Substrat 8 ausgebildete Streifenleitungen 9 ausgebildet sind, wie dies für Messungen an einem Meßobjekt 16 vorteilhaft ist, das auf einem rückseitig mit einer Massefläche kaschierten und auf einem Träger 17 aus Metall befestigten Substrat 11 in Streifenleitungstechnik ausgebildet und zwischen den Streifenleitungen 9 der Meßtore 6 und 7 beispielsweise über Bonddrähte 12 geschaltet wird.

Fig. 3 zeigt in Draufsicht schematisch den Kalibriervorgang für einen Netzwerkanalysator, dessen Meßtore 6 und 7 gemäß Fig. 2 ausgebildet sind und zwischen denen anstelle des Meßobjekts 11, 16 ein Kalibrierstandard 13, 14, 15 geschaltet ist.

Gemäß Fig. 3a wird zunächst zwischen die beiden im beliebigen Abstand voneinander angeordneten Meßtore 6 und 7 eine auf einem wieder rückseitig eine Massefläche aufweisenden Substrat 15 ausgebildete Streifenleitung 13 beliebiger Länge geschaltet, die Verbindung zwischen der Streifenleitung 13 mit den

Streifenleitungen 9 der Meßtore 6 und 7 erfolgt wieder über Bonddrähte 12. Mit dieser Anordnung nach Fig. 3a wird zunächst eine erste Kalibriermessung durchgeführt und die Transmissions- und Reflexionsparameter dieser Streifenleitung 13 ermittelt.

Anschließend werden gemäß Fig. 3b, 3c und 3d drei weitere Kalibriermessungen mit der gleichen unverändert zwischen die Meßtore 6 und 7 geschalteten Streifenleitungen 13 durchgeführt, wobei zunächst an der Stelle X1 der Streifenleitung 13 ein Klotz 14 beispielsweise aus dielektrischem Material oder für sehr hohe Frequenzen eventuel auch aus Metall aufgesetzt wird, der als reflexionssymmetrische und reziproke Störgröße in der Leitung 13 wirkt, beispielsweise als ein in die Leitung zwischengeschalteter Kondensator. Nach Durchführung der Kalibriermessung mit der Anordnung nach Fig. 3b wird dieser Klotz 14 in die Stellung X2 verschoben und wieder eine Kalibriermessung durchgeführt, abschließend wird eine letzte Kalibriermessung mit der Anordnung nach Fig. 3d mit dem Klotz 14 in der Stellung X3 durchgeführt. Der Abstand 1 zwischen den Verschiebestellungen X1,X2,X3 kann im Prinzip verschieden sein, zur Erleichterung der Auswertung ist dieser Abstand 1 vorzugsweise jedoch gleich groß gewählt.

Der Druck, mit dem der Klotz 14 auf die Streifenleitung 13 aufgedrückt wird, muß für die drei Kalibriermessungen nach Fig. 3b, 3c und 3d gleich groß sein, da hiervon die Kalibriergenauigkeit abhängt.

Mit einer Kalibrieranordnung nach Fig. 3 kann auf einfache Weise auch die Ausbreitungskonstante der Leitung 13 ermittelt werden, dazu ist es nur erforderlich, die Abstände 1 während der Messung exakt mechanisch zu vermessen, daraus kann dann unter Berücksichtigung der während der Kalibriermessung ermittelten Streuparameter die Ausbreitungskonstante exakt berechnet werden, auch hierfür ist es von Vorteil, wenn die Abstände äquidistant sind.

Fig. 4 zeigt die Anwendung des erfindungsgemäßen Kalibrierverfahrens bei einem Netzwerkanalystor, dessen Meßtore 6 und 7 im Freiraum liegen und durch Antennen gebildet sind, beispielsweise durch Hornstrahler 20, 21, die in einem vorbestimmten Abstand voneinander angeordnet sind und zwischen sich ein elektromagnetisches Feld aufbauen. Mit einer solchen Anordnung werden beispielsweise Feuchtigkeitsmessungen an einem dazwischenliegenden Meßobjekt durchgeführt. Bei dieser Freiraum-Meßanordnung ist das erfindungsgemäße Verfahren besonders einfach durchführbar, da hier ja die Ausbreitungskonstante in Luft bekannt ist, in diesem Fall sind nur insgesamt drei Kalibriermessungen nötig.

Gemäß Fig. 4a werden die beiden Hornstrahler 20, 21 in einem beliebigen Abstand voneinander angeordnet und damit dann eine erste Kalibriermessung durchgeführt. Anschließend wird dann gemäß Fig. 4b eine Kugel 22, beispielsweise aus dielektrischem Material oder gegebenenfalls auch aus Metall, an einer Stelle X1 im Raum zwischen den beiden im gleichen Abstand gehaltenen Hornstrahlern 20, 21 angeordnet und damit eine zweite Kalibriermessung durchgeführt. Anschließend wird diese Kugel 22 dann gemäß Fig. 4c in die Position X2 verschoben und erneut eine Kalibriermessung durchgeführt. Mit den so gewonnenen Meßwerten können alle Streuparameter ermittelt werden, die für eine Fehlerkorrektur erforderlich sind.

Dieses Verfahren nach Fig. 4 mit nur insgesamt drei Kalibriermessungen ist auch für Leitungen dann geeignet, wenn die Ausbreitungskonstante der Leitung bekannt ist, wie dies für Präzisions-, Luftleitungen oder Hohlleiter der Fall ist. Für solche Leitungen reduziert sich das Kalibrierverfahren nach Fig. 3 auf die Schritte a, b und c.

Fig. 5 zeigt eine solche mit einem Kohlleiter 37 aufgebaute Kalibriereinrichtung, die eine vollautomatische Kalibrierung eines Netzwerkanalysators ermöglicht. Die Meßtore 6 und 7 werden in diesem Beispiel durch Koaxialkupplungen 33 und 34 gebildet, auf die entsprechende Koaxialkupplungen 35, 36 eines Kalibrierstandards 30 aufsetzbar sind. Diese Koaxialkupplungen 35 und 36 führen über Koaxialleitungen in den Hohlleiter 37, die Meßsignale werden durch nicht dargestellte Kupplungseinrichtungen im Hohlleiter 37 in die Hohlleiterwelle umgesetzt. In der einen Seitenwand des Hohlleiters 37 sind Bohrungen vorgesehen, in welche von außen dielektrische Körper 31 und 32 ein- und ausfahrbar sind und zwar automatisch über einen nicht dargestellten elektromagnetischen Antrieb, durch den diese dielektrischen Körper 31 und 32 in Richtung der Doppelpfeile 38 und 39 axial verschiebbar sind. Während der ersten Kalibriermessung sind beide Körper 31, 32 aus dem Hohlleiter herausgezogen und es wird eine erste Kalibriermessung nur mit dem zwischen die Meßtore 6, 7 geschalteten Hohlleiter 37 durchgeführt. Anschließend wird an der Stelle X1 über den Antrieb der erste Körper 31 in den Hohlleiter eingefahren und damit eine zweite Kalibriermessung durchgeführt. Dann wird der Körper 31 wieder aus dem Hohlleiter 37 herausgezogen und dafür der zweite Körper 32 an der Stelle X2 in den Hohlleiter eingeführt und wieder eine Kalibriermessung durchgeführt. Diese drei aufeinanderfolgenden Kalibriermessungen können vollautomatisch über den im Kalibrierstandard 30 eingebauten Antrieb nacheinander durchgeführt werden, so daß mit einem solchen Kalibrierstandard 30 erstmals eine vollautomatische Kalibrierung möglich ist.

Die Ermittlung der Streuparameter aus den Meßwerten erfolgt in bekannter Weise beispielsweise nach Heuermann, Eul, Schiek, "Robuster Algorithmus zur Streuparameterbestimmung für systemfehlerkorrigierte Netzwerkanalysatoren", Kleinheubacher Berichte 1991, Band 35, die Meßwerte bei der eigentlichen Objektmessung werden bei bekannten Korrekturgrößen ($A_{ij}$ - bzw. $B_{ij}$-Koeffizienten) nach dieser Verfahrensweise von den Systemfehlern befreit. Aus dem Prinzipschaltbild nach Fig. 1 ist ersichtlich, daß der Netzwerkanalysator vier Meßstellen aufweist.

Die nachfolgenden mathematischen Erklärungen zur Ermittlung der Korrekturkoeffizienten bauen auf der Arbeit von Eul, Schiek, " A Generalized Theorie and New Calibration Prozedures für Network-Analyzer Selfcalibration" IEEE, Transactions on Mikrowave Theory and Technics, MTG 39, March 1991 auf.

In Transmissionsparameterdarstellung werden die Vektorgleichungen der voneinander unabhängigen Meßwerte $m_1$, $m_2$, $m_3$ und $m_4$ für die erste Schalterstellung I und $m_1'$ , $m_2'$ , $m_3'$ , $m_4'$ für die zweite Schalterstellung II nach der sogenannten Viertorzweitorreduktion zu einer Matrixgleichung kombiniert:

$$\begin{pmatrix} m_1 & m_1' \\ m_2 & m_2' \end{pmatrix} = [A][N][B]^{-1} \begin{pmatrix} m_3 & m_3' \\ m_4 & m_4' \end{pmatrix} , \qquad (1)$$

$$\Rightarrow [M] = [A][N][B]^{-1}, \qquad (2)$$

mit der Meßwertmatrix

$$[M] = \begin{pmatrix} m_1 & m_1' \\ m_2 & m_2' \end{pmatrix} \begin{pmatrix} m_3 & m_3' \\ m_4 & m_4' \end{pmatrix}^{-1} . \qquad (3)$$

Bei den $A_{ij}$- und $B_{ij}$-Koeffizienten der 2*2-Matrizen [A] und [B] handelt es sich um die 8 gesuchten Korrekturgrößen, die sich dadurch auf 7 reduzieren lassen, daß man eine der 8 Korrekturgrößen festlegt. Betrachtet man in Fig.3 als Referenzebenen zur Herleitung der sogenannten Selbstkalibrierng zunächst die linke und die mittlere Linie, so ergibt sich mit der Leitungs-Durchverbindung ([L]) für die erste Kalibriermessung:

$$\Rightarrow [M_L] = [A][L][B]^{-1} , \qquad (4)$$

mit

$$[L] = \begin{pmatrix} e^{-\gamma \ell} & 0 \\ 0 & e^{+\gamma \ell} \end{pmatrix} = \begin{pmatrix} E_1 & 0 \\ 0 & \frac{1}{E_1} \end{pmatrix} , \qquad (5)$$

wobei folgende Abkürzung eingeführt wurde:

$$E_1 = e^{-\gamma \ell} . \qquad (6)$$

Mit $\gamma$ wird die Ausbreitungskonstante und mit $\ell$ die Länge des Leitungssystems bezeichnet.

Die Transmissionsparametermatrix des Kalibrierobjektes wird mit [Q] bezeichnet. Es läßt sich für die zweite Kalibriermessung

$$[M_{N1}] = [A][N1][B]^{-1} , \qquad (7)$$

formulieren, wobei gilt

$$[N1] = [Q][L] , \qquad (8)$$

mit

$$[Q] = \begin{pmatrix} q_{11} & q_{12} \\ q_{21} & q_{22} \end{pmatrix} \quad . \qquad (9)$$

Laut eines Satzes aus der linearen Abbildungstheorie, gilt: Quadratische Matrizen $[A_1]$ und $[A_2]$, für die

$$[A_2] = [S]^{-1} [A_1][S] \text{ bzw. } [S][A_2] = [A_1][S] \qquad (10)$$

gilt ( [S]: reguläre Matrix ), heißen ähnlich. Ähnliche Matrizen besitzen folgende Eigenschaften:

$$\mathrm{spur}([A_1]) = \mathrm{spur}([A_2]) \text{ ; } \det([A_1]) = \det([A_2]) \text{ .} \qquad (11)$$

Mit "det" ist die Determinante und mit " spur" die sogenannte Spur, die aus der Summe der Matrixelemente der Hauptdiagonalen gebildet wird, einer quadratischen Matrix bezeichnet.

Aus Gleichung (4) folgt

$$[B]^{-1} = [L]^{-1}[A]^{-1}[M_L] \text{ ,} \qquad (12)$$

eingesetzt in der Gleichung (7) folgt

$$[M_{N1}][M_L]^{-1} = [A][N1][L]^{-1}[A]^{-1} \text{ .} \qquad (13)$$

Unter Anwendung des Satzes für ähnliche Matrizen ergibt sich

$$\underbrace{\mathrm{spur}\left([M_{N1}][M_L]^{-1}\right)}_{\beta_1} = \mathrm{spur}\left([N1][L]^{-1}\right) \quad , \qquad (14)$$

woraus sich die erste Selbstkalibriergleichung zur Bestimmung des unbekannten Kaiibrierzweitores Q ergibt:

$$\beta_1 = q_{11} \div q_{22} \qquad (15)$$

Verknüpft man die zweite mit der dritten Kalibriermessung, so erhält man über die Auswertung von

$$\underbrace{\mathrm{spur}\left([M_{N1}][M_{N2}]^{-1}\right)}_{\beta_2} = \mathrm{spur}\left([N1][N2]^{-1}\right) \quad , \qquad (16)$$

mit

$$[N2] = [L][Q] \qquad (17)$$

die zweite notwendige Bestimmungsgieichung:

$$2 - \beta_2 = q_{12}\, q_{21}\, (2 \cosh (2\gamma \ell) - 2) \text{ .} \qquad (18)$$

Verwendet wurde dabei noch die postulierte Eigenschaft, daß [Q] die Matrix eines reziproken Zweitores ist:

$$1 = q_{11}\, q_{22} - q_{12}\, q_{21} \text{ .} \qquad (19)$$

Betrachtet man in Fig.3 die linke und rechte Linie als Referenzlinien, so läßt sich durch die Verknüpfung der zweiten und vierten Kalibriermessung über

$$\underbrace{\mathrm{spur}\left([M_{N1}][M_{N3}]^{-1}\right)}_{\beta_3} = \mathrm{spur}\left([N1][N3]^{-1}\right) \quad , \qquad (20)$$

mit

$[N1] = [Q][L][L]$ ; $[N3] = [L][L][Q]$ (21)

die letzte notwendige Bestimmungsgleichung für die Selbstkalibriergrößen herleiten.

$2 - \beta_3 = q_{12}\, q_{21}\, (2 \cosh (4\gamma \ell)-2)$ (22)

Dividiert man Gleichung (18) durch Gleichung (22), so erhält man eine quadratische Gleichung zur Ermittlung dar komplexen Ausbreitungskonstante $\gamma$ bei bekannter mechanischer Länge $\ell$:

$$\cosh(2\gamma\ell) = \frac{1}{4\beta_4}\left\{1 \pm \sqrt{1 - 8\beta_4 + 16\beta_4^2}\right\} \quad , \qquad (23)$$

wobei $\beta_4$ folgendermaßen definiert ist :

$$\beta_4 = \frac{2-\beta_2}{2-\beta_3} \quad . \qquad (24)$$

Um die Vorzeichenentscheidung zu fällen, ist es notwendig, eine Vorabinformation über die Ausbreitungskonstante zu besitzen, was jedoch für die Praxis keine Einschränkung darstellt.

Für den Fall, daß die Ausbreitungskonstante $\gamma$ bekannt ist, entfallen die Rechenschritte von der Gleichung (20) bis zur Gleichung (24).

Wurde die mechanische Länge $\ell$ falsch vorgegeben, dann ist das Ergebnis für $\gamma$ ebenfalls falsch, jedoch ist das Produkt $\gamma\ell$ noch exakt. Da im weiteren beide Größen nur in dieser Produktform auftreten, hat die Vorgabe einer falschen mechanischen Länge keinen Einfluß auf die Kalibriergenauigkeit.

Berücksichtigt man die eingangs geforderte Eigenschaft, daß das Netzwerk reflexionssymmetrisch ist, so gilt in Transmissionsparametern:

$q_{21} = - q_{12}$ . (25)

Eingesetzt in der Beziehung (18) erhält man

$$q_{21} = \pm\sqrt{\frac{\beta_2 - 2}{2\cosh(2\gamma\ell) - 2}} \quad . \qquad (26)$$

Setzt man (15) in (19) ein, so erhält man nach kurzer Rechnung die Bestimmungsgleichungen für die beiden weiteren $q$-Größen:

$$q_{11} = \frac{\beta_1}{2} \pm \sqrt{\frac{\beta_1^2}{4} + q_{21}^2 - 1} \qquad (27)$$

und direkt aus (15)

$$q_{22} = \beta_1 - q_{11} . \quad (28)$$

Wenn man das Problem in Streupararmetern umformuliert, reduzieren sich die Vorzeichenentscheidungen auf die Auswertung der Passivität der Kalibrierstandards.

Weiterhin muß ( ähnlich wie bei den bisherigen Kalibrierverfahren ) die Phase des Reflexionsverhaltens des Netzwerkes auf 180° zur Treffung der zweiten Vorzeichenentscheidung bekannt sein.

Nachdem alle $q_{ij}$-Koeffizienten und das Ausbreitungskonstanten-Längen-Produkt $\gamma \ell$ bekannt sind, ist die sogenannte Selbstkalibrierung abgeschlossen. Somit stehen 4 Kalibriermessungen mit vollständig bekannten Standards zur Verfügung. Um die $A_{ij}$- und $B_{ij}$ -Korrekturkoeffizienten zu berechnen benötigt man jedoch nur 3 Kalibriermessungen mit bekannten Standards.

Somit hat man genügend Informationen zur Verfügung, um auf dem konventionellen Weg die Korrekturgrößen zu berechnen.

Möchte man mit nicht äquidistanten Schrittweiten arbeiten, so erhält man aus der Gleichung (23) eine nichtlineare Gleichung, aus der die Ausbreitungskonstante $\gamma$ nur noch numerisch ermittelt werden kann. Ansonsten bleibt die weitere Rechnung gleich.

Führt man noch zusätzlich eine oder mehrere Messungen des Kalibrierobjektes auf weiteren Positionen durch, so kann man die Redundanz durch die Einführung einer Ausgleichsrechnung nutzen.

## Patentansprüche

1. Verfahren zum Kalibrieren eines Netzwerkanalysators, der zwei Meßtore aufweist, die über Leitungen mit einem Meßobjekt verbindbar sind, dadurch **gekennzeichnet**, daß mit einer ersten Kalibriermessung die Transmissions- und Reflexions-Parameter an einer reflexionsfrei zwischen die beiden Meßtore geschalteten Leitung unbekannter Ausbreitungskonstante, insbesondere an einer Streifen-Leitung gemessen werden und mit dieser gleichen Leitung drei weitere Kalibriermessungen an drei Kalibrierstandards durchgeführt werden, die durch an drei verschiedenen Stellen in diese Leitung eingefügte reflexionssymmetrische und reziproke Störobjekte realisiert sind.

2. Verfahren zum Kalibrieren eines Netzwerkanalysators, der zwei Meßtore aufweist, die über Leitungen mit einem Meßobjekt verbindbar sind, dadurch **gekennzeichnet**, daß mit einer ersten Kalibriermessung die Transmissions- und Reflexions-Parameter an einer reflexionsfrei zwischen die beiden Meßtore geschalteten Präzisions-Leitung bekannter Ausbreitungskonstante, insbesondere an einem Hohlleiter, gemessen werden und mit dieser gleichen Präzisions-Leitung zwei weitere Kalibriermessungen an zwei Kalibrierstandards durchgeführt werden, die durch an zwei verschiedenen Stellen in die Präzisionsleitung eingefügte reflexionssymmetrische und reziproke Störobjekte realisiert sind.

3. Verfahren zum Kalibrieren eines Netzwerkanalysators, der zwei Meßtore aufweist, die über Strahler und den freien Raum mit einem Meßobjekt verbindbar sind, dadurch **gekennzeichnet**, daß mit einer ersten Kalibriermessung die Transmissions- und Reflexions-Parameter zwischen den in einem festen Abstand voneinander angeordneten Strahlern der Freiraumverbindung gemessen werden und an zwei weiteren Kalibrierstandards zwei weitere Kalibriermessungen durchgeführt werden, die durch an zwei verschiedenen Stellen zwischen den Strahlern angeordnete für elektromagnetische Wellen reflexionssymmetrische und reziproke Störobjekte realisiert sind.

4. Vefahren nach Anspruch 3, dadurch **gekennzeichnet**, daß die im Freiraum zwischen den Strahlern angeordneten Störobjekte durch eine Platte oder Kugel realisiert sind.

5. Verfahren nach einem der vorhergehenden Ansprüche, dadurch **gekennzeichnet**, daß zur automatischen Kalibrierung die Störobjekte zwischen den verschiedenen Kalibrierstellungen mittels einer steuerbaren Antriebseinrichtung bewegbar sind.

6. Verfahren nach einem der vorhergehenden Ansprüche, dadurch **gekennzeichnet**, daß die mechanischen Abstände zwischen den verschiedenen Kalibrierstellungen der Störobjekte gleich groß gewählt sind.

7. Verfahren nach einem der vorhergehenden Ansprüche, dadurch **gekennzeichnet**, daß die aufeinanderfolgenden drei oder vier Kalibriermessungen mit mindestens zwei verschieden großen Meßtorabständen und damit verschiedenen Leitungslängen bzw. Strahlerabständen durchgeführt werden (Breitbandkalibrierung).

8. Verfahren nach Anspruch 1 oder 2, dadurch **gekennzeichnet**, daß die mechanischen Abstände zwischen den verschiedenen Stellungen der Störobjekte längs der Leitung bestimmt werden und daraus sowie den während der Kalibrierung gewonnenen Meßwerten die Ausbreitungskonstante der Leitung berechnet wird.

9. Kalibriervorrichtung zum Ausführen eines Verfahrens nach Anspruch 1 für einen zwei Meßtore (6, 7) aufweisenden Netzwerkanalysator, **gekennzeichnet** durch eine zwischen die beiden Meßtore (6, 7) des Netzwerkanalysators schaltbare elektrische Leitung (13, 15) sowie einen an drei verschiedenen Stellen (X1, X2, X3) längs der Leitung auf diese aufsetzbaren, das elektromagnetische Feld auf der Leitung beeinflussenden Körper (14).

10. Kalibriervorrichtung nach Anspruch 9, dadurch **gekennzeichnet**, daß der Körper (14) mittels einer steuerbaren Antriebseinrichtung an den verschiedenen Stellen auf die Leitung aufsetzbar ist.

11. Kalibriervorrichtung nach Anspruch 9 oder 10, dadurch **gekennzeichnet**, daß der Körper (14) längs der Leitung (13, 15) mechanisch verschiebbar angeordnet ist.

12. Kalibriervorrichtung nach Anspruch 9, 10 oder 11, dadurch **gekennzeichnet**, daß der Körper (14) aus dielektrischem Material besteht.

13. Kalibriervorrichtung nach Anspruch 9, dadurch **gekennzeichnet**, daß die elektrische Leitung eine auf einem Substrat (15) in Streifenleitungstechnik ausgebildete Streifenleitung (13) ist, die über Bonddrähte (12) mit den in Streifenleitungstechnik ausgebildeten Anschlüssen (9) der Meßtore (6, 7) verbindbar ist.

14. Kalibriervorrichtung zum Ausführen eines Verfahrens nach Anspruch 2 für einen zwei Meßtore (6, 7; 33, 34) aufweisenden Netzwerkanalysator, **gekennzeichnet** durch einen zwischen die beiden Meßtore (33, 34) schaltbaren Hohlleiter (37), in den an mindestens zwei verschiedenen Stellen (X1, X2) jeweils Körper (31, 32), durch die das elektromagnetische Feld im Hohlleiter beeinflußbar ist, von außen ein- und ausfahrbar sind.

15. Kalibriervorrichtung nach Anspruch 14, dadurch **gekennzeichnet**, daß die beiden Körper (31, 32) über einen mechanischen Antrieb durch Öffnungen in der Seitenwand des Hohlleiters in diesen ein- und ausfahrbar sind (Bewegungspfeile 38, 39).

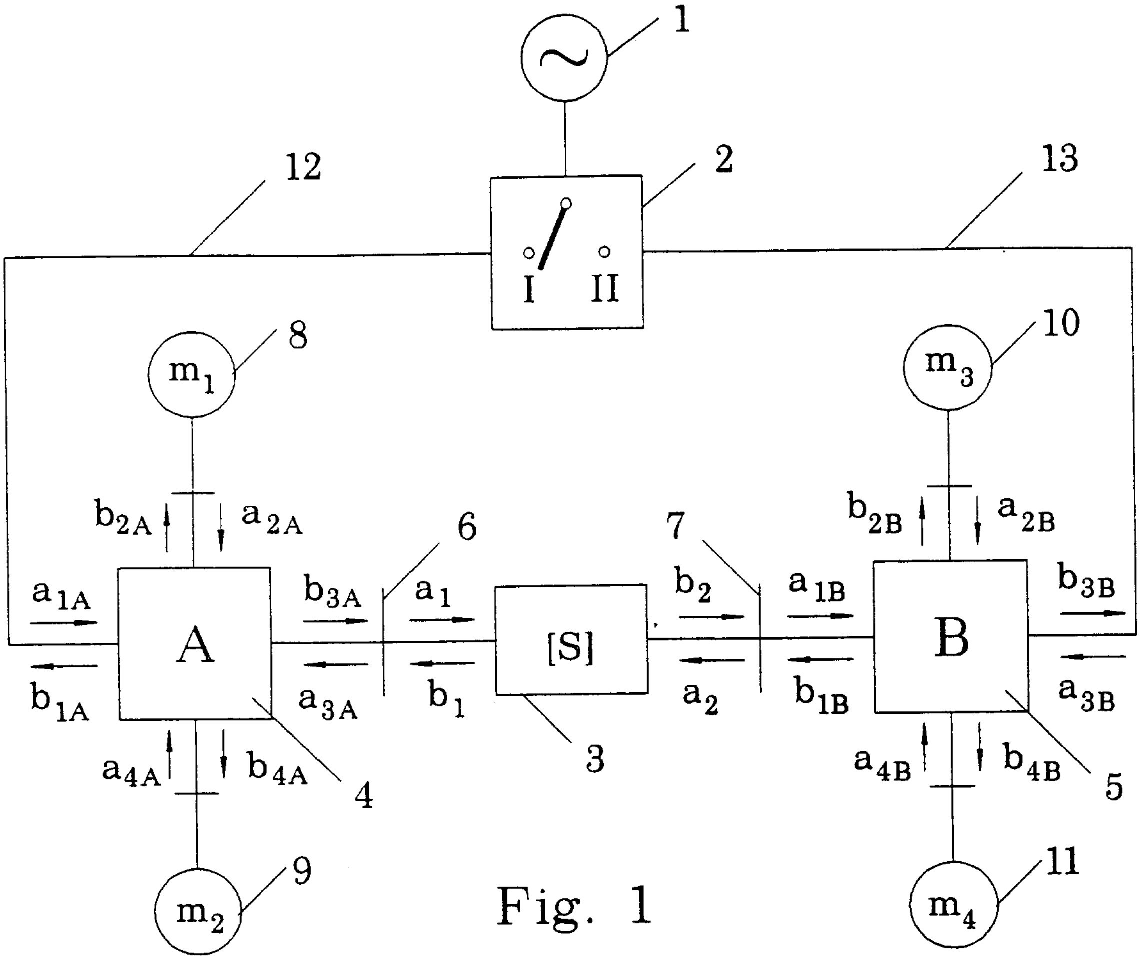
1
2
12
13
I
II
8
10
$m_1$
$m_3$
$b_{2A}$
$a_{2A}$
$b_{2B}$
$a_{2B}$
6
7
$a_{1A}$
A
$b_{3A}$
$a_1$
[S]
$b_2$
$a_{1B}$
B
$b_{3B}$
$b_{1A}$
$a_{3A}$
$b_1$
$a_2$
$b_{1B}$
$a_{3B}$
$a_{4A}$
$b_{4A}$
4
3
$a_{4B}$
$b_{4B}$
5
9
11
$m_2$
$m_4$

Fig. 1

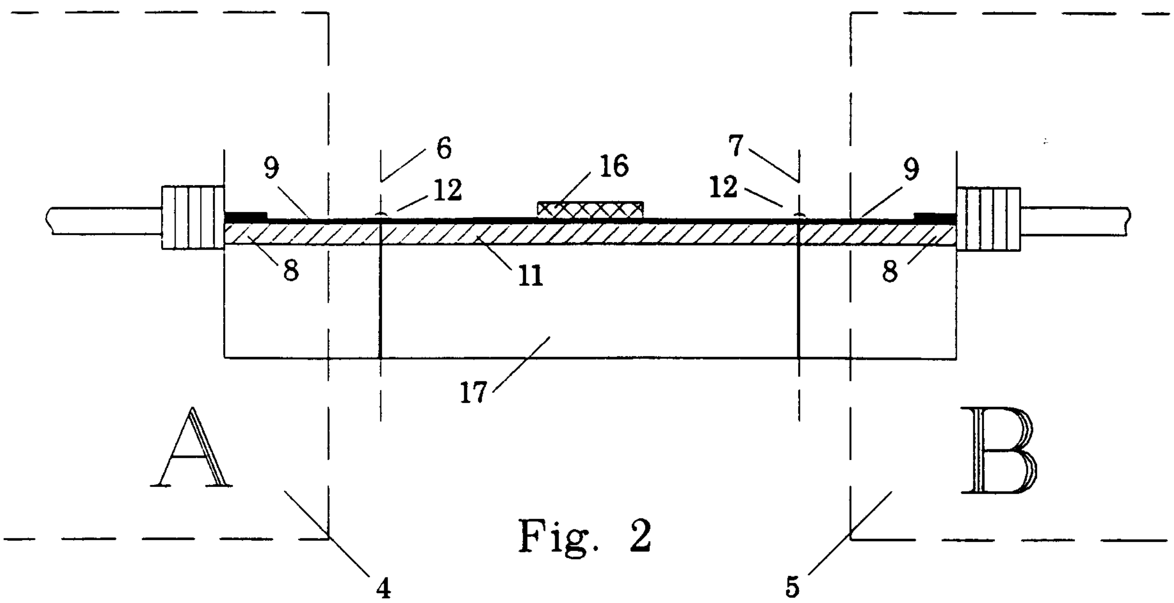


Fig. 2

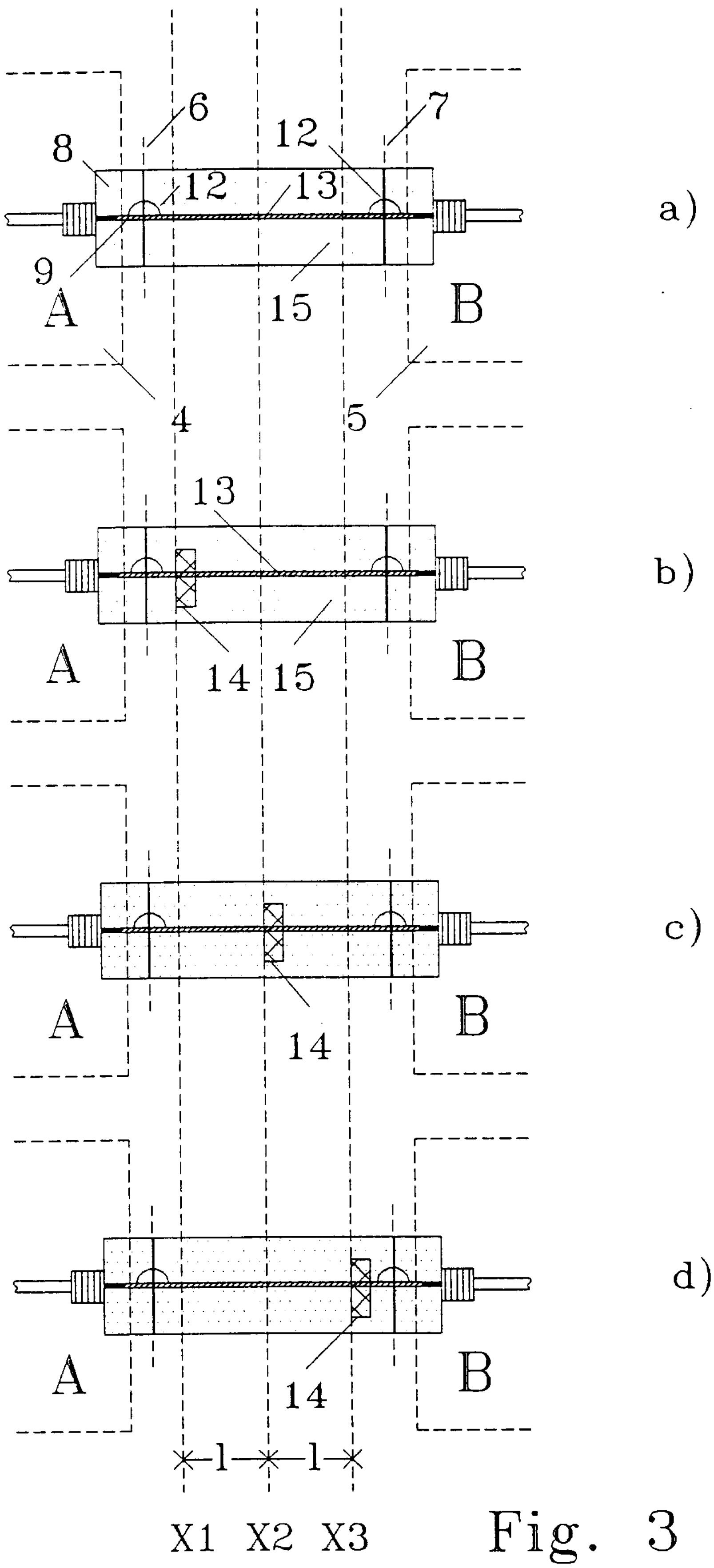


Fig. 3

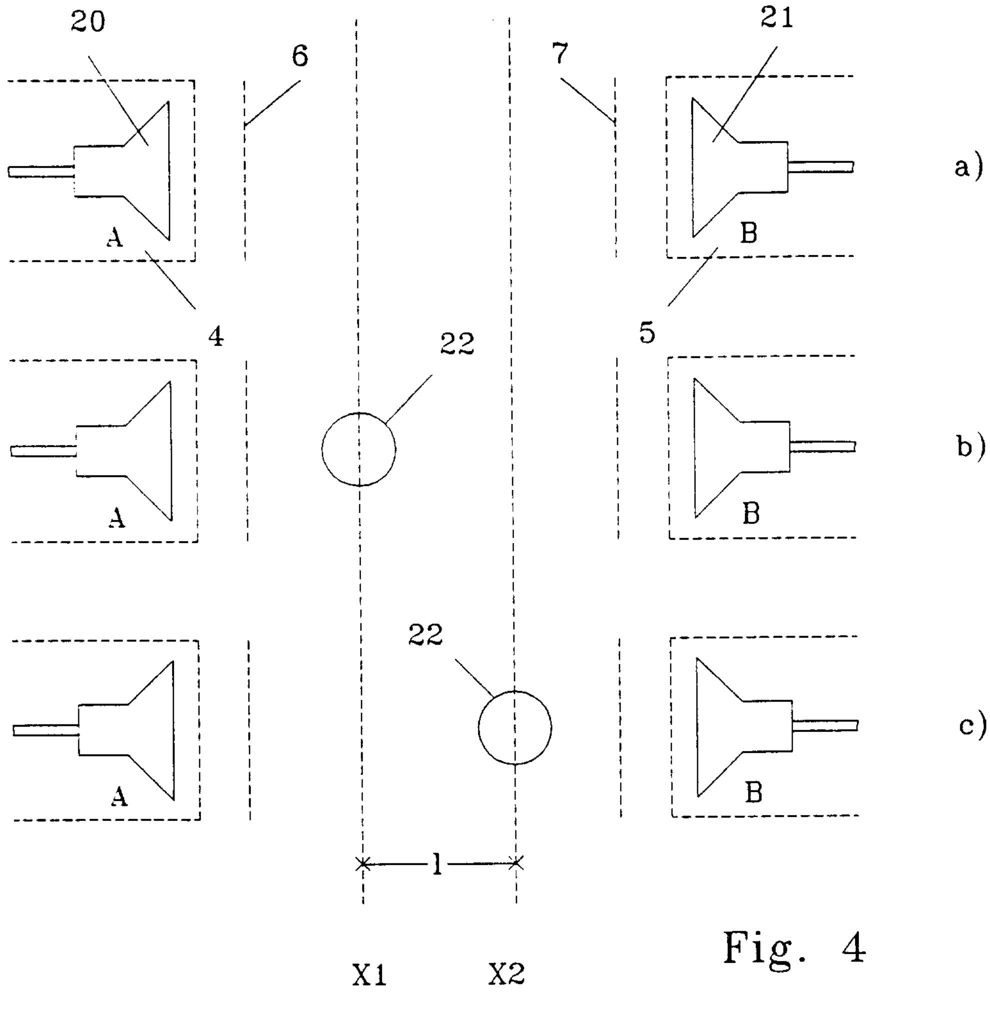


Fig. 4

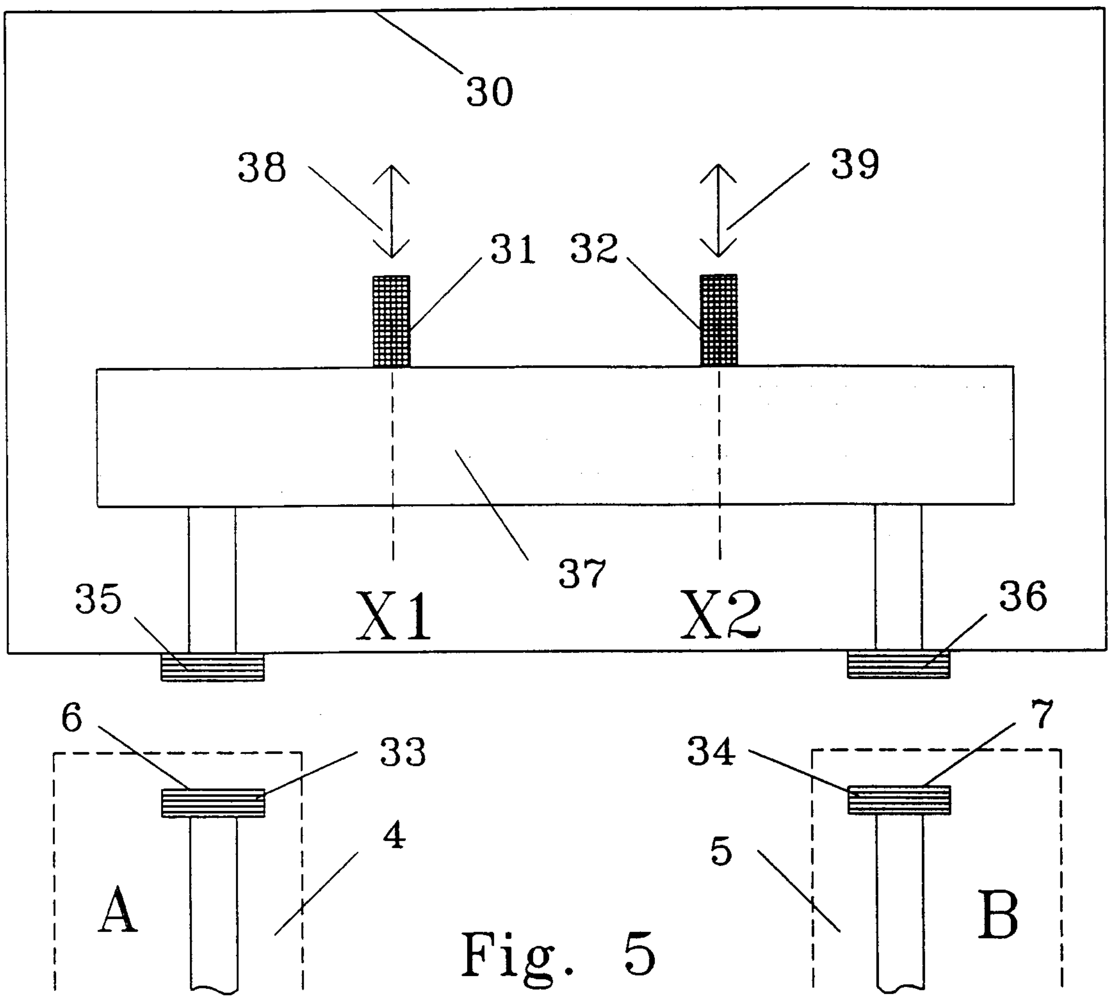


Fig. 5